# EUROPÄISCHE PATENTSCHRIFT

(11) **EP 2 831 923 B1**
(45) Veröffentlichungstag und Bekanntmachung des Hinweises auf die Patenterteilung: **31.07.2019**
(21) Anmeldenummer: 13711705.7
(22) Anmeldetag: 25.03.2013
(51) Int. Cl.: H01L 31/048, B32B 17/10, B32B 37/10, B32B 37/12, B32B 38/00, C09J 175/14

(54) **VERWENDUNG VON UV-STRAHLENHÄRTBAREN POLYURETHANHARZEN ZUR HERSTELLUNG VON SOLARLAMINATEN**
USE OF UV CURABLE POLYURETHANE RESINS FOR PRODUCING SOLAR LAMINATES
UTILISATION DE RÉSINES DE POLYURÉTHANE DURCISSABLES PAR RAYONNEMENTS UV POUR LA FABRICATION DE LAMINÉS SOLAIRES

(30) Priorität: 27.03.2012 EP 12161382
(43) Veröffentlichungstag der Anmeldung: 04.02.2015
(73) Patentinhaber: Covestro Deutschland AG, 51373 Leverkusen (DE)
(72) Erfinder: ROTHE, Bernd, 50678 Köln (DE); GESCHKE, Jens, 47802 Krefeld (DE); ACHTEN, Dirk, 51375 Leverkusen (DE); KUCZEWSKI, Helmut, 47475 Kamp-Lintfort (DE); FISCHER, Wolfgang, 40668 Meerbusch (DE)
(74) Vertreter: Michalski Hüttermann & Partner Patentanwälte mbB
(86) Internationale Anmeldenummer: PCT/EP2013/056310
(87) Internationale Veröffentlichungsnummer: WO 2013/144095

(56) Entgegenhaltungen:
- WO-A1-2013/030062
- DE-A1- 19 855 146
- JP-A- 2011 068 839
- JP-A- 2011 071 387
- JP-A- 2011 071 447
- US-A- 4 953 577
- US-A1- 2003 036 620
- US-A1- 2011 120 546
- US-A1- 2011 214 717

## Beschreibung

Die vorliegende Erfindung betrifft die Verwendung einer strahlenhärtbare Harzzusammensetzung zur Herstellung von Solarlaminaten, ein Verfahren zur Erzeugung eines Solarlaminats mit Hilfe der erfindungsgemäßen Harzzusammensetzung sowie ein Solarlaminat, das nach diesem Verfahren herstellbar ist.

Bei Solarzellen oder Photovoltaikanlagen handelt es sich um Halbleiter, die zur Umwandlung von Licht in Elektrizität verwendet werden. Diese werden im Folgenden allgemein als Solarzellen beschrieben. Typischerweise generieren Solarzellen unter Lichteinstrahlung eine Potentialdifferenz zwischen gegenüberliegenden Enden der Solarzelle, welche ein Resultat eines Elektronenflusses ist, welcher durch die Lichteinstrahlung generiert wird. Die Höhe des Potentials hängt von der Intensität des Lichts ab, das auf die Solarzelle trifft.

Solarzellen können aus verschiedenartigen Halbleitermaterialien hergestellt werden, wie beispielsweise aus einkristallinem oder polykristallinem Silizium oder als Dünnschichtzellen aus amorphem oder halbkristallinem Silizium, Galliumarsenid, Kupfer-Indium-diselinid, Cadmiumtellurid, Kupfer-Indium-Galliumdiselenid, oder Mischungen von diesen.

Grundsätzlich unterscheidet man zwischen zwei verschiedenen Typen von Solarzellen, nämlich Waver-basierten Solarzellen auf der einen Seite und Dünnfilm-Solarzellen auf der anderen Seite. Bei einem Waver handelt es sich um eine dünne Schicht halbleitenden Materials, welche durch einen Sägeprozess von einem einkristallinen oder polykristallinen Zylinder abgeschnitten wird. Dem gegenüber basieren Dünnschichtsolarzellen auf abgeschiedenen Lagen eines Halbleitermaterials auf einem Substrat, wobei die Abscheidung beispielsweise über Sputtern, PVD (physical vapor deposition), CVD (chemical vapor deposition) oder ähnliche Techniken erzeugt wird.

Unabhängig von der Herstellung, sind sowohl Waver-basierte als auch Dünnschicht-basierte Solarzellen mechanisch empfindlich und werden deshalb bei der Verwendung als Solarzellen mit einer Trägerschicht kombiniert. Diese Trägerschicht, die der mechanischen Versteifung (z.B. Sicherung gegen Biege- oder Schlagvorfälle), kann ein starres Material, wie beispielsweise eine Glasplatte sein, oder ein flexibles Material, wie ein metallischer Film oder Lagen aus geeignetem Kunststoffmaterial, wie beispielsweise Polyamid-Folien.

Ein Solarzellenmodul oder ein photovoltaisches Modul (im Weiteren als Solarzellenmodul bezeichnet) umfasst eine einzelne Solarzelle oder eine planare Anordnung von miteinander verbundenen Solarzellen auf einer Trägerschicht. Solarzellenmodule sind typischerweise verkapselt, um die einzelnen Zellen vor der Einwirkung von Störeinflüssen zu schützen. Dabei kann die mechanische Verstärkungsschicht eines Solarzellenmoduls beispielsweise als transparente Deckschicht ausgebildet sein. Es ist jedoch ebenso möglich, die mechanische Verstärkungsschicht auf der Rückseite des Solarzellenmoduls vorzusehen. Oft werden diese beiden Möglichkeiten auch miteinander kombiniert, so dass Solarzellenmodule eine mechanisch stabilisierende Deckschicht und ein mechanisch stabilisierendes Substrat umfassen.

Häufig werden Serien von Solarzellenmodulen miteinander verbunden, um sogenannte Solararrays zu bilden. Dabei werden mehrere Solarzellenmodule in der Weise miteinander verbunden, dass geeignete Spannungen erzeugt werden, um elektrische Anlagen mit der erforderlichen Spannung zu versorgen.

Im Allgemeinen werden Solarzellenmodule durch elektrische Verbindungen der einzelnen Solarzellen miteinander und Laminierung der so verbundenen Zellen zwischen einer Deckschicht und einem Substrat hergestellt. Dabei wird die Laminierung in der Weise durchgeführt, dass nicht nur eine ausreichende mechanische Stabilität für die Solarzellenmodule sichergestellt ist, sondern diese auch von Umgebungseinflüssen wie Wind, Schnee, Regen, Verschmutzung und ähnlichem geschützt sind.

Waver-basierte Solarzellenmodule werden typischerweise mit einer transparenten Deckschicht hergestellt, welche in der Regel mittels einer Klebeschicht fixiert ist. Folglich durchdringt das Licht sowohl die Oberschicht als auch die Klebeschicht, bevor es auf die Halbleiteroberfläche des Wavers trifft. Die rückseitige mechanische Schutzschicht wird gleichermaßen mit einer oder mehreren Lagen eines Verkapselungsmaterials auf der Waverückseite befestigt.

Im Stand der Technik ist eine große Anzahl verschiedener Verkapselungsmaterialien für Solarzellenmodule bekannt. So werden beispielsweise Ethylen-Vinylacetatcopolymere (EVA), Tedlar® von Dupont und thermoplastische Polyurethanfolien sowie UV-härtbare Urethane verwendet. Die Verkapselungsmaterialien werden typischerweise als Film verwendet, um die vorgenannten Bauelemente der Solarzellen miteinander zu laminieren. Die vorgenannten Materialien sowie Verfahrensweisen sind beispielsweise aus US 4,331,494 bekannt. Auch Acrylatbasierte Polymere zur Herstellung wetterresistenter Schichten sind vorbekannt, wie sie beispielsweise in US 4,374,995 beschrieben sind. Ferner ist es auch bekannt, Solarzellenmodule durch Aufbringen und Aushärten Acrylat-basierter Präpolymere einzusetzen. Dies ist beispielsweise in US 4,549,033 beschrieben. Aus US 6,320,116 und EP 0 406 814 A1 sind weitere Verkapselungssysteme für Solarzellen oder photovoltaische Systeme bekannt.

Ferner ist in WO 2009/007786 A2 ein Laminierklebstoff beschrieben, welcher ein Siloxanbasiertes Präpolymer beinhaltet. Bei Einsatz eines solchen Klebstoffs entsteht ein Silikonharzfilm, mit dem das Halbleitermaterial und die Deckschichten miteinander verbunden werden.

Ein ähnliches Material ist aus WO 2005/006451 A1 bekannt. In dieser Offenlegungsschrift wird ein Verkapselungsmaterial für Solarzellen beschrieben, welches ein flüssiges Diorganopolysiloxan mit zumindest zwei Siliziumalkenylgruppen pro Molekül aufweist. Dieses Präpolymer wird auf die miteinander zu verbindenden Bauelemente der Solarzelle aufgebracht und thermisch oder über Infrarotstrahlung ausgehärtet.

Die vorgenannten Verfahrensweise sind mit verschiedenen Nachteilen verbunden. So werden die vorgenannten zur Herstellung von Laminaten für Solarmodule eingesetzten Folien aus EthylenVinylacetat zunächst zwischen die zu verklebenden Schichten eingelegt. Anschließend wird diese Schichtstruktur unter Vakuum auf ca. 140°C für bis zu vierzig Minuten erhitzt, um eine ausreichende Fügefestigkeit zu erreichen. Dabei schmilzt die EVA-Folie und fixiert nach dem Erkalten den Schichtverbund. Dieser vakuumbasierte Prozess ist einerseits aufwendig und zudem stellt eine Erhitzung der Solarzellenmodule auf 140°C für die Halbleiterbauelemente eine Belastung dar, welche sich nachteilig auf die Haltbarkeit und Effizienz der Solarzellen auswirken kann. Siloxanhaltige Klebstoffe sind vergleichsweise teuer und besitzen nicht auf allen Substraten eine ausreichende Adhäsion.

US 8,034,455 B2 beschreibt die Verwendung von UV-härtbaren Zusammensetzungen, die zur Beschichtung von Solarmodulen verwendet werden können. Aus US 8,034,455 B2 ergibt sich kein Hinweis, ob und wie UV-härtbare Zusammensetzungen zum Verkleben von Solarmodulen verwendet werden können, sodass eine ausreichende Haftung zwischen einzelnen Schichten auch in Schattenbereichen erzielt wird. JP 2011 071387 A beschreibt eine Rückseitenschutzschicht für ein Solarzellenmodul, bestehend aus mindestens einer Schutzschicht (A), einer Primerschicht (B), einer Polvester-basierten Schicht (C) und einem Substrat (D) aus einem thermoplastischen Polymer. In der Rückseitenschutzschicht wird die äußere Schutzschicht (A) durch Vernetzung und Aushärten eines strahlenhärtbaren Harzes gebildet, wobei die Primerschicht (B) aus einem Polvurethanharz (P) besteht, das durch Vernetzung und Härten eines Urethan-basierten Prepolymers mit einem Isocyanat-basierten Vernetzer hergestellt wird.

Ausgehend von dem vorgenannten Stand der Technik bestand die Aufgabe der vorliegenden Erfindung darin, eine Harzzusammensetzung zur Verfügung zu stellen, die sich zur Herstellung von Solarlaminaten in einfach ausführbaren, kontinuierlichen Verfahren eignet, wobei die Harzzusammensetzung zu einer guten Haftung in allen Bereichen zwischen den einzelnen Schichten der Solarlaminate führt.

Diese Aufgabe wird erfindungsgemäß durch Verwendung einer strahlenhärtbaren Harzzusammensetzung umfassend wenigstens eine isocyanatfunktionelle Verbindung, die wenigstens eine strahlenhärtende Gruppe ausgewählt aus der Gruppe bestehend aus Vinyl-, Propenyl-, Allyl-, Vinylether-, Maleinyl-, Fumaryl-, Maleinimid-, Dicyclopentadienyl-, Acrylamid- und (Meth)Acrylat-Gruppen aufweist, (Komponente A) und wenigstens ein Polyol (Komponente B) zur Herstellung von Solarlaminaten, umfassend wenigstens eine Solarzelle mit einer Vorderseite, einer Rückseite und dort angeschlossenen Rückseitenkontakten sowie eine Rückseitenfolie, wobei die strahlenhärtbare Zusammensetzung wenigstens einen Initiator (Komponente E) aufweist gelöst.

"(Meth)Acrylat" bezieht sich im Rahmen dieser Erfindung auf entsprechende Acrylat- oder Methacrylatfunktionen oder auf eine Mischung beider.

Das nachveröffentlichte Dokument WO 2013/030062 A1 betrifft ein Solarmodul, umfassend eine erste Schicht, eine über der ersten Schicht angeordnete Solarzelle und eine über der Solarzelle angeordnete zweite Schicht. Die erste und/oder die zweite Schicht umfassen einen Faserverbundwerkstoff, welcher ein thermisch und mittels elektromagnetischer Strahlung vernetztes, vorzugsweise aliphatisches Polyurethanpolymer umfasst. Das Material der Fasern des Faserverbundwerkstoffes ist wenigstens im Bereich des sichtbaren Lichts transparent. Weiterhin betrifft das Dokument die Verwendung eines solchen Solarmoduls und ein Verfahren zu seiner Herstellung.

Der unbestimmte Artikel "einer", "eine" ist nicht als zahlenmäßige Limitierung sondern als "mindestens einer" beziehungsweise "mindestens eine" zu verstehen, sofern dies nicht explizit ausgeschlossen wird.

Strahlenhärtende Gruppen im Sinne der vorliegenden Erfindung sind funktionelle Gruppen, die unter Einwirkung aktinischer Strahlung durch Polymerisation reagieren. Unter aktinischer Strahlung wird elektromagnetische, ionisierende Strahlung verstanden, insbesondere Elektronenstrahlen, UV-Strahlen sowie sichtbares Licht (Roche Lexikon Medizin, 4. Auflage; Urban & Fischer Verlag, München 1999). Unter Einwirkung aktinischer Strahlung mit ethylenisch ungesättigten Verbindungen unter Polymerisation reagierende Gruppen (strahlenhärtende Gruppen) werden im Rahmen der vorliegenden Erfindung Vinyl-, Propenyl-, Allyl-, Vinylether-, Maleinyl-, Fumaryl-, Maleinimid-, Dicyclopentadienyl-, Acrylamid- und (Meth)Acrylat-Gruppen verstanden, wobei dies bevorzugt Vinylether- und/oder (Meth)Acrylat-Gruppen, besonders bevorzugt (Meth)Acrylat-Gruppen sind.

Überraschenderweise hat sich herausgestellt, dass durch die Verwendung einer strahlenhärtbaren Harzzusammensetzung der vorgenannten Art eine Erhitzung beim Laminierschritt entfallen kann, wodurch sich die Fügung der unterschiedlichen Komponenten deutlich vereinfacht. So können die erfindungsgemäß verwendeten Zusammensetzungen beispielsweise bei Raumtemperatur verarbeitet werden, wodurch nicht nur thermische Energie eingespart wird, sondern auch die Belastung der Solarzellenmodule während der Herstellung durch starkes Erwärmen entfällt.

Die erfindungsgemäß verwendete Harzzusammensetzung kann beispielsweise durch Einwirkung von aktinischer Strahlung, bei Bedarf auch durch thermische Aktivierung ausgehärtet werden. Hierzu wird als Komponente E) ein entsprechender Initiator der Zusammensetzung zugesetzt, der bei der gewünschten Methode in der Lage ist, eine Polymerisation insbesondere der Doppelbindungen der Komponenten C) und/ oder D) zu starten. Die hierfür erforderlichen Substanzen und Einsatzmengen sind dem Fachmann bekannt. Soll hochenergetische Strahlung wie Elektronenstrahlung verwendet werden, muss in der Regel kein Initiator zugesetzt werden.

In einer bevorzugten Ausführungsform bezieht sich die vorliegende Erfindung daher auch auf die Verwendung einer strahlenhärtbaren Harzzusammensetzung umfassend wenigstens eine isocyanatfunktionelle Verbindung, die wenigstens eine strahlenhärtende Gruppe ausgewählt aus der Gruppe bestehend aus Vinyl-, Propenyl-, Allyl-, Vinylether-, Maleinyl-, Fumaryl-, Maleinimid-, Dicyclopentadienyl-, Acrylamid- und (Meth)Acrylat-Gruppen aufweist, (Komponente A), wenigstens ein Polyol (Komponente B), wenigstens ein ungesättigtes Urethanacrylat, das keine Isocyanatgruppen trägt, (Komponente C), und wenigstens eine (Meth)Acrylatkomponente (Komponente D) zur Herstellung von Solarlaminaten.

In einer besonders bevorzugten Ausführungsform bezieht sich die vorliegende Erfindung daher auch auf die Verwendung einer strahlenhärtbaren Harzzusammensetzung umfassend wenigstens eine isocyanatfunktionelle Verbindung, die wenigstens eine strahlenhärtende Gruppe ausgewählt aus der Gruppe bestehend aus Vinyl-, Propenyl-, Allyl-, Vinylether-, Maleinyl-, Fumaryl-, Maleinimid-, Dicyclopentadienyl-, Acrylamid- und (Meth)Acrylat-Gruppen aufweist, (Komponente A),
wenigstens ein Polyol (Komponente B),
wenigstens ein ungesättigtes Urethanacrylat, das keine Isocyanatgruppen trägt, (Komponente C), wenigstens eine (Meth)Acrylatkomponente (Komponente D) und
wenigstens einen Initiator (Komponente E) zur Herstellung von Solarlaminaten.

In bevorzugter Weise ist die erfindungsgemäß verwendete Harzzusammensetzung frei von Lösungsmitteln mit einem Siedepunkt < 150 °C, insbesondere < 200°C. Hierunter wird verstanden, dass allenfalls Spuren solcher Substanzen enthalten sind, beispielsweise maximal 0,5 Gew.-% bezogen auf die Harzzusammensetzung, insbesondere maximal 0,1 Gew.-%.

Die erfindungsgemäß einsetzbaren isocyanatfunktionellen Verbindungen sind beispielsweise aus Polyisocyanaten aufgebaut, wobei ein Teil der ursprünglich vorhandenen NCO-Gruppen mit hydroxyfunktionellen Verbindungen, die funktionelle Gruppen ausgewählt aus der Gruppe bestehend aus Vinyl-, Propenyl-, Allyl-, Vinylether-, Maleinyl-, Fumaryl-, Maleinimid-, Dicyclopentadienyl-, Acrylamid- und (Meth)Acrylat-Gruppen aufweisen, umgesetzt wurde, sodass das die isocyanatfunktionelle Verbindung Vinyl-, Propenyl-, Allyl-, Vinylether-, Maleinyl-, Fumaryl-, Maleinimid-, Dicyclopentadienyl-, Acrylamid- und/oder (Meth)Acrylat-Gruppen sowie Isocyanatgruppen trägt.

Als Polyisocyanate werden typischerweise aromatische, aliphatische und cycloaliphatische Polyisocyanate mit einem zahlenmittleren Molekulargewicht von unter 800 g/mol eingesetzt. Beispielsweise geeignet sind Diisocyanate aus der Reihe 2,4-/2,6-Toluoldiisocyanat (TDI), Methylendiphenyldiisocyanat (MDI), Triisocyanatononan (TIN), Naphtyldiisocyanat (NDI), 4,4'-Diisocyanatodicyclohexylmethan, 3-Isocyanatomethyl-3,3,5-trimethylcyclohexylisocyanat (Isophorondiisocyanat = IPDI), Tetramethylendiisocyanat, Hexamethylendiisocyanat (HDI), 2-Methylpentamethylendiisocyanat, 2,2,4-Trimethylhexamethylendiisocyanat (THDI), Dodecamethylendiisocyanat, 1,4-Diisocyanato-cyclohexan, 4,4'-Diisocyanato-3,3'-dimethyl-dicyclohexylmethan, 4,4'-Diisocyanatodicyclohexylpropan-(2,2), 3-Isocyanatomethyl-1-methyl-1-isocyanatocyclohexan (MCI), 1,3-Diisooctylcyanato-4-methyl-cyclohexan, 1,3-Diisocyanato-2-methyl-cyclohexan und α,α,α',α'-Tetramethyl-m- oder -p-xylylen-diisocyanat (TMXDI) sowie aus diesen Verbindungen bestehende Gemische.

Bevorzugte Ausgangsstoffe für die Herstellung der isocyanatfunktionellen Verbindungen sind Hexamethylendiisocyanat (HDI), Isophorondiisocyanat (IPDI) und/oder 4,4'-Diisocyanatodicyclohexylmethan.

Ebenfalls geeignet als Polyisocyanate sind Umsetzungsprodukte der vorgenannten Isocyanate mit sich selbst oder untereinander zu Uretdionen, oder Isocyanuraten. Beispielhaft genannt seien Desmodur® N3300, Desmodur® N3400 oder Desmodur® N3600 (alle Bayer MaterialScience, Leverkusen, DE). Weiterhin geeignet sind auch Derivate von Isocyanaten, wie Allophanate oder Biurete. Beispielhaft genannt seien Desmodur® N100, Desmodur® N75MPA/BA oder Desmodur® VPLS2102 (alle Bayer MaterialScience, Leverkusen, DE).

Beispiele hydroxylgruppenhaltiger Verbindungen, die strahlenhärtende Gruppen aufweisen, sind 2-Hydroxyethyl(meth)acrylat, Polyethylenoxid-mono(meth)acrylat (z.B. PEA6 / PEM6; Laporte Performance Chemicals Ltd., UK), Polypropylenoxidmono(meth)acrylat (z.B. PPA6, PPM5S; Laporte Performance Chemicals Ltd., UK), Polyalkylenoxidmono(meth)acrylat (z.B. PEM63P, Laporte Performance Chemicals Ltd., UK), Poly(ε-caprolacton)mono(meth)-acrylate wie z.B. Tone M100® (Dow, Schwalbach, DE), 2-Hydroxypropyl(meth)acrylat, 4-Hydroxybutyl(meth)acrylat, Hydroxybutylvinylether, 3-Hydroxy-2,2-dimethylpropyl(meth)acrylat, die hydroxyfunktionellen Mono-, Di- oder soweit möglich höheren Acrylate wie z.B. Glycerindi-(meth)acrylat, Trimethylolpropandi(meth)acrylat, Pentaerythrittri(meth)acrylat oder Dipentaerythritpenta(meth)acrylat, die durch Umsetzung mehrwertiger gegebenenfalls alkoxylierter Alkohole wie Trimethylolpropan, Glycerin, Pentaerythrit, Dipentaerythrit zugänglich sind.

Ferner können als solche OH-funktionellen Verbindungen, die strahlenhärtende Gruppen aufweisen, auch die Umsetzungsprodukte von doppelbindungshaltigen Säuren mit gegebenenfalls doppelbindungshaltigen Epoxidverbindungen, wie die Umsetzungsprodukte von (Meth)Acrylsäure mit Glycidyl(meth)acrylat oder Bisphenol-A-diglycidylether, in der Urethanisierung eingesetzt werden.

Bevorzugt ist die isocyanatfunktionelle Verbindung, die wenigstens eine strahlenhärtende Gruppe ausgewählt aus der Gruppe bestehend aus Vinylether-, Maleinyl-, Fumaryl-, Maleinimid-, Dicyclopentadienyl-, Acrylamid- und (Meth)Acrylat-Gruppen aufweist, ein isocyanatfunktionelles Urethanacrylat. Unter einem Urethanacrylat werden solche Verbindungen verstanden, die zumindest eine Isocyanatgruppe und wenigstens eine Acrylatgruppe pro Molekül aufweisen. Derartige Systeme sind an sich bekannt und besitzen die Eigenschaft, sowohl über eine NCO/OH Reaktion mit Polyolen oder Polyaminen, als auch über die Acrylatfunktion mittels UV-Licht oder Elektronenstrahlung radikalisch zu polymerisieren. Da zwei verschiedene Polymerisationsmechanismen bei diesen Verbindungen zum Tragen kommen werden Zusammensetzungen, die solche Verbindungen enthalten, auch als "dual-cure"-Systeme bezeichnet.

Die erfindungsgemäß einsetzbaren isocyanatfunktionellen Urethanacrylate sind beispielsweise aus Polyisocyanaten aufgebaut, wobei ein Teil der ursprünglich vorhandenen NCO-Gruppen mit hydroxyfunktionellen Acrylaten oder Methacrylaten umgesetzt wurde, sodass das Molekül endständige (Meth)Acrylatgruppen sowie Isocyanatgruppen trägt.

Dabei kommen als Ausgangsverbindung für isocyanatfunktionelle Urethanacrylate monomere Di- oder Triisocyanate in Betracht. Beispiele für geeignete monomere Polyisocyanate sind 1,5-Naphthylendiisocyanat, 2,2'-, 2,4- und/oder 4,4'-Diphenylmethan-diisocyanat (MDI), hydriertes MDI (H12MDI), Xylylendiisocyanat (XDI), Tetramethylxylylendiisocyanat (TMXDI), 4,4'-Diphenyldimethyl-methandiisocyanat, 4,4'-Dibenzyldiisocyanat, 1,3-Phenylendiisocyanat, 1,4-Phenylendiisocyanat, Toluylendiisocyanats (TDI), 1-Methyl-2,4-diisocyanato-cyclohexan, 1,6-Diisocyanato-2,2,4-trimethylhexan, 1,6-Diisocyanato-2,4,4-trimethylhexan, 1 -Isocyanatomethyl-3 - isocyanato-1,5,5-trimethylcyclohexan (IPDI), Tetramethoxybutan-1,4-diisocyanat, Hexan-1,6-diisocyanat (HDI), Dicyclohexylmethandiisocyanat, Cyclohexan-1,4-diisocyanat, Ethylendiisocyanat, Trimethylhexamethylendiisocyanat, 1,4-Diisocyanatobutan, 1,12-Diisocyanatododecan, Dimerfettsäurediisocyanat, oder Uretdion-, Biuret- oder Isocyanurate von Diisocyanaten. Auch Isocyanat-Trimere können verwendet werden, wie sie beispielsweise in EP 1 002 818 B1 beschrieben sind, deren Offenbarung per Verweis als in die vorliegende Anmeldung übernommen gilt.

Als hydroxyfunktionelle Acrylate oder Methacrylate kommen im Prinzip sämtliche denkbaren Verbindungen dieser Art zum Einsatz. Die Verbindungen enthalten mindestens einen einwertig Hydroxy-funktionellen Ester der (Meth)acrylsäure. Darunter sind sowohl eine freie Hydroxylgruppe aufweisende Ester der Acrylsäure oder Methacrylsäure mit zweiwertigen Alkoholen zu verstehen wie beispielsweise 2-Hydroxyethyl-, 2- oder 3-Hydroxypropyl oder 2-, 3- oder 4-Hydroxybutyl-(meth)acrylat als auch beliebige Gemische aus derartigen Verbindungen. Außerdem kommen auch einwertige (Meth)Acryloylgruppen aufweisende Alkohole oder im Wesentlichen aus derartigen Alkoholen bestehende Umsetzungsprodukte in Betracht, die durch Veresterung von n-wertigen Alkoholen mit (Meth)Acrylsäure erhalten werden, wobei als Alkohole auch Gemische von unterschiedlichen Alkoholen eingesetzt werden können, so dass n für eine ganze oder in statistische Mittel gebrochene Zahl von größer 2 bis 4, vorzugsweise 3 steht, und wobei pro Mol der genannten Alkohole von (n-0,8) bis (n-1,2), vorzugsweise (n-1) Mol (Meth)Acrylsäure eingesetzt werden. Zu diesen Verbindungen bzw. Produktgemischen gehören beispielsweise die Umsetzungsprodukte von Glycerin, Trimethylolpropan und/oder Pentaerythrit, von niedermolekularen Alkoxylierungsprodukten derartiger Alkohole, wie beispielsweise ethoxyliertem oder propoxyliertem Trimethylolpropan, wie beispielsweise dem Anlagerungsprodukt von Ethylenoxid an Trimethylolpropan der OH-Zahl 550 oder von beliebigen Gemischen derartiger mindestens dreiwertiger Alkohole mit zweiwertigen Alkoholen wie beispielsweise Ethylenglykol oder Propylenglykol mit (ii) (Meth) Acrylsäure im genannten Molverhältnis.

Zur Erzeugung erfindungsgemäß einsetzbarer Urethanacrylate ist es ebenso möglich, von einer polymeren Verbindung ausgewählt aus der Gruppe bestehend aus Polyester(meth)acrylaten, Polyether(meth)acrylaten, Polyetherester(meth)acrylaten, ungesättigten Polyestern mit Allyletherstruktureinheiten und Polyepoxy(meth)acrylaten auszugehen. Diese polymere Verbindung bildet das Polymerrückgrat und wird zur Erzeugung des Urethanacrylats mit Polyisocyanaten umgesetzt. Die Isocyanatgruppen der erhaltenen Urethanacrylate können dann gewünschtenfalls wiederum mit monomeren Verbindungen mit jeweils einer Hydroxyfunktion und mindestens einer (Meth)Acrylatgruppe umgesetzt werden, wodurch endständige Acrylatgruppen erzeugt werden. Wird nur ein Teil der Isocyanatgruppen umgesetzt, werden isocyanatfunktionelle Urethanacrylate erhalten. Werden die Isocyanatgruppen vollständig umgesetzt, wird ein ungesättigtes Urethanacrylat erzeugt.

In besonderer Ausgestaltung der erfindungsgemäß verwendeten Harzzusammensetzung besitzt das isocyanatfunktionelle Urethanacrylat eine NCO-Funktionalität von 0,8 bis 6, bevorzugt 1 bis 4, weiter bevorzugt 1,2 bis 3, ganz besonders bevorzugt 1,5 bis 2,5 und insbesondere 2. Dies ist besonders vorteilhaft, weil dadurch eine gute Haftung auf verschiedensten Materialien wie Kunstoffen, Metallen und Glas erzeugt werden kann.

Was die Doppelbindungsfunktionalität des isocyanatfunktionellen Urethanacrylats betrifft, so kann diese über weite Bereiche variieren. Vorzugsweise beträgt die Doppelbindungsfunktionalität 0,5 bis 6, bevorzugt 1 bis 4, weiter bevorzugt 1,5 bis 3. Die Doppelbindungsfunktionalität definiert sich hierbei als statistische mittlere Anzahl an Doppelbindungen pro Molekül des isocyanatfunktionellen Urethanacrylats.

In weiter bevorzugter Weise weist das isocyanatfunktionelle Urethanacrylat ein mittleres Molekulargewicht von 150 bis 5000 auf, insbesondere von 300 bis 2500.

Weiterhin enthält die erfindungsgemäß verwendete Harzzusammensetzung wenigstens ein Polyol (Komponente B). Zu diesem Zweck kann jedes Polyol eingesetzt werden, das im Stand der Technik beispielsweise zur Herstellung von Polyurethanpolymeren bekannt ist. Hierfür kommen insbesondere Polyetherpolyole, Polyesterpolyole, Polyetherpolyesterpolyole, Polycarbonatpolyole, Polyestercarbonatpolyole oder Polyethercarbonatpolyole in Frage. Weitere Beispiele sind aliphatische Alkohole und Polyole mit 1-6 OH-Gruppen pro Molekül und 2 bis etwa 30 C-Atomen. Geeignete aliphatische Polyole sind beispielsweise Ethylenglykol, Propandiol-1,2 oder -1,3, Butandiol-1,4, Butandiol-1,3, Butandiol-2,3, Butendiol-1,4, Pentandiol-1,5, Pentendiole, Hexandiol-1,6, Octandiol-1,8, Dodecandiol und höhere Homologe, Isomere und Gemische solcher Verbindungen. Ebenfalls geeignet sind höherfunktionelle Alkohole wie beispielsweise Glycerin, Trimethylolpropan, Pentaerythrit oder Zuckeralkohole, wie Sorbit oder Glucose, sowie oligomere Ether oder Umsetzungsprodukte mit Ethylen- oder Propylenoxid. Weiterhin können die Umsetzungsprodukte niedermolekularer, polyfunktioneller Alkohole mit Alkylenoxiden, sogenannte Polyetherpolyole, eingesetzt werden. Die Alkylenoxide weisen vorzugsweise zwei bis etwa vier C-Atome auf. Geeignet sind beispielsweise die Umsetzungsprodukte von Ethylenglykol, Propylenglykol, Glycerin, Trimethylolethan oder Trimethylolpropan, Pentaerythrit mit Ethylenoxid, Propylenoxid oder Butylenoxid oder Gemischen davon. Die genannten Alkohole können dabei selber auch "dual- funktional" sein, d.h. somit auch ungesättigte Doppelbindungen und Hydroxygruppen aufweisen, wobei die Doppelbindung z.b. durch teilweise Veresterung mit Acrylsäure oder Umsetzung mit Di- oder Polyisocyanaten und weitere Umsetzung - wie oben beschrieben - mit hydroxyfunktionellen Doppelbindungsträgern erhalten werden können.

Das Molekulargewicht der Polyole kann über weite Bereiche variieren. Vorzugsweise liegt das Molekulargewicht (M_{N}) der Polyole bei etwa 50 bis 5000 g/mol (zahlenmittleres Molekulargewicht, M_{N}, wie durch GPC bestimmbar), insbesondere von 150 bis 2500 g/mol. Solche Polyole sind dem Fachmann bekannt und kommerziell erhältlich.

Insbesondere zeichnet sich die das Polyol durch eine OH-Funktionalität von 1 bis 6 aus, bevorzugt 1,5 bis 5, weiter bevorzugt 1,7 bis 4, besonders bevorzugt 1,8 bis 3,5 und ganz besonders bevorzugt 2.

Im Rahmen der vorliegenden Erfindung ist vorgesehen, dass die Harzzusammensetzung optional ein ungesättigtes Urethanacrylat (Komponente C) aufweist. Dieses unterscheidet sich also von dem isocyanatfunktionellen Urethanacrylat darin, dass es keine freien NCO-Gruppen trägt. Die erfindungsgemäß eingesetzten ungesättigten Urethanacrylate sind, wie auch die isocyanatfunktionellen Urethanacrylate, aus einem polyfunktionellen Isocyanat aufgebaut, wobei in Falle der ungesättigten Urethanacrylate sämtliche der Isocyanatgruppen mit einem hydroxyfunktionellen Acrylat oder Methacrylat umgesetzt sind. Auch die vorstehend bei den isocyanatfunktionellen Urethanacrylaten beschriebene Alternative mit einem polymeren Backbone aus Polyester(meth)acrylaten, Polyether(meth)acrylaten, Polyetherester(meth)acrylaten, ungesättigten Polyestern mit Allyletherstruktureinheiten und Polyepoxy(meth)acrylaten kann zur Anwendung kommen.

Was die für die ungesättigten Urethanacrylate einsetzbaren polyfunktionellen Isocyanate betrifft, so kommen hierfür grundsätzlich dieselben Verbindungen in Frage, die vorstehend zu den isocyanatfunktionellen Urethanacrylaten angegeben sind.

Vorzugsweise sind die polyfunktionellen Isocyanate für die ungesättigten Urethanacrylate aus den aliphatischen polyfunktionellen Isocyanaten ausgewählt. Mit anderen Worten ist also ein ungesättigtes aliphatisches Urethanacrylat als Komponente C) bevorzugt. Diese Verbindungen sind besonders bevorzugt, weil sie die Flexibilität der erfindungsgemäß verwendeten Zusammensetzung nach dem Aushärten verbessern. Dies ist besonders beim Einsatz als Laminierklebstoff für bei Solarzellen von großer Bedeutung, weil dadurch die Schlag und Stoßunempfindlichkeit verbessert wird. Außerdem wird durch die verbesserte Flexibilität eine Delamination der einzelnen Schichten der Solarzelle durch sich ständig ändernde Temperaturbeanspruchung verhindert.

In weiterer Ausgestaltung der Erfindung weist das ungesättigte Urethanacrylat einen Anteil an OH-Gruppen auf. Die OH-Funktionalität ist in der Regel gering und kann beispielsweise 0,01 bis 1 betragen, bevorzugt 0,05 bis 0,8, weiter bevorzugt 0,08 bis 0,6, ganz besonders bevorzugt 0,09 bis 0,5 und insbesondere 0,1. Diese OH-Gruppen stehen ebenfalls für eine Reaktion mit NCO-Gruppen zur Verfügung.

In weiter bevorzugter Weise weist das ungesättigte Urethanacrylat ein mittleres Molekulargewicht von 200 bis 3000 auf, insbesondere von 300 bis 2000.

Die Doppelbindungsfunktionalität des ungesättigten Urethanacrylats kann über weite Bereiche variieren. Vorzugsweise beträgt die Doppelbindungsfunktionalität 1 bis 6, bevorzugt 2 bis 5 weiter bevorzugt 2,5 bis 4. Die Doppelbindungsfunktionalität definiert sich hierbei als statistische mittlere Anzahl an Doppelbindungen pro Molekül des ungesättigten Urethanacrylats.

Die erfindungsgemäß verwendeten Harzzusammensetzungen zeichnen sich weiterhin durch das optionale Vorhandensein einer (Meth)Acrylatkomponente aus (Komponente D). Diese (Meth)Acrylatkomponente kann aus aliphatischen und/oder aromatischen Methacrylaten ausgewählt sein. Einsetzbare Alkyl(meth)acrylate sind beispielsweise lineare oder verzweigte monofunktionale ungesättigte (Meth)Acrylate nicht tertiärer Alkylalkohole, deren Alkylgruppen 4 bis 14 und insbesondere 4 bis 12 Kohlenstoffatome aufweisen. Beispiele solch niederer Alkylacrylate sind n-Butyl, n-Pentyl, n-Hexyl, Cyclohexyl, Isoheptyl, n-Nonyl, n-Decyl, Isohexyl, Isobornyl, 2-Ethyloctyl, Isooctyl, 2-Ethylhexyl, Tetrahydrofurfuryl, Ethoxyethoxyethyl, Phenoxyethyl, Cyclo-Trimethlypropan, 3,3,5-Trimethylcyclohexyl, t-Butylcyclohexyl, t-Butylacrylate und -methacrylate. Bevorzugte Alkylacrylate sind Isooctylacrylat, 2-Ethylhexylacrylat, 2- Ethyloctylacrylat, n-Butylacrylat, Tetrahydrofurfurylacrylat, Isobornylacrylat, Ethoxyethoxyethylacrylat, Phenoxyethylacrylat, 3,3,5-trimethylcyclohexylacrylat sowie Cyclohexylacrylat.

Nach einer weiteren bevorzugten Ausführungsform der erfindungsgemäß verwendeten Harzzusammensetzung ist die Komponente E ausgewählt aus der Gruppe umfassend UV-Initiatoren, thermisch aktivierbare Initiatoren und Redoxinitiatoren.

Als photoaktivierbare Initiatoren können beispielsweise Benzoinether verwendet werden, wie Benzoinmethylether, Benzoinisopropylether, substituierte Benzoinether wie Anisoinmethylether, Acetophenone, wie 2,2-Diethoxyacetophenon, substituierte Acetophenone wie 2,2-Diethoxyacetophenon, 2,2-Dimethoxy-2-Phenylacetophenon und 1-Phenyl-2-Hydroxy-2-Methyl-1-Propanon, substituierte alpha-Ketole, wie 2-Methyl-2-Hydroxypropiophenon, aromatische Sulphonylchloride und photoaktive Oxime wie 1-Phenyl-1,1-Propanedion-2-(O-Ethoxycarbonyl) Oxim.

Als thermisch aktivierbare Initiatoren kommen organische Peroxide in Betracht, wie Ditertiärbutylperoxid, Benzoylperoxid und Laurylperoxid, sowie 2,2'-Azobis(isobutyronitril).

Die Einsatzmengen der vorgenannten Initiatoren sind dem Fachmann grundsätzlich bekannt und betragen beispielsweise etwa 0,01 bis 8 Gew.-%, insbesondere 0,5 bis 5 Gew.-%, bevorzugt 1 bis 3 Gew.-%.

Weiterhin kann die erfindungsgemäß verwendete Zusammensetzung noch übliche Additive beinhalten. Hierfür kommen beispielsweise dem Fachmann bekannte Füllstoffe, Stabilisatoren, insbesondere UV-Stabilisatoren, Fungizide, Farbstoffe, Pigmente, Polymerisationskatalysatoren, Weichmacher und Lösungsmittel in Betracht. Als Polymerisationskatalysator können beispielsweise an sich bekannte Isocyanatadditionskatalysatoren verwendet werden, wie z. B Triethylamin, 1,4-Diazabicyclo-[2,2,2]-Oktan, Zinndioktoat, Dibutylzinndilaurat oder Bismuthoctoat.

Nach einer besonders bevorzugten Ausführungsform der erfindungsgemäß verwendeten Harzzusammensetzung enthält diese die Komponenten in den folgenden Mengen:

| | |
|---|---|
| Komponente A) | 10 bis 79,9 Gew.-%, insbesondere 15 bis 75 Gew.-%, |
| Komponente B) | 20 bis 89,9 Gew.-%, insbesondere 25 bis 85 Gew.-%, |
| Komponente C) | 0 bis 50 Gew.-%, insbesondere 15 bis 30 Gew.-%, |
| Komponente D) | 0 bis 35 Gew.-%, insbesondere 10 bis 25 Gew.-% sowie |
| Komponente E) | 0,1 bis 8 Gew.-%, insbesondere 0,5 bis 5 Gew.-%. |

Die Verwendung dieser Zusammensetzung ist besonders bevorzugt, weil sie sich in besonderer Weise zur Herstellung von Solarlaminaten eignet. So vereinigt diese Zusammensetzung eine gute Adhäsion auf den typischerweise verwendeten Substraten, besitzt eine hohe Langzeitstabilität gegenüber Umwelteinflüssen, ist ausreichend flexibel um Spannungen im Laminat zu kompensieren und lässt sich zudem einfach und schnell verarbeiten.

Eine weiter bevorzugte Harzzusammensetzung gemäß der vorliegenden Erfindung zeichnet sich dadurch aus, dass die Komponenten A) und B) grundsätzlich getrennt voneinander gelagert werden, wobei C), D) sowie gegebenenfalls E) in einer Vormischung nach Bedarf den Komponenten A) und B) zugemischt sind.

Ein weiterer Gegenstand der vorliegenden Erfindung betrifft ein Verfahren zur Herstellung eines Solarlaminats umfassend wenigstens eine Solarzelle mit einer Vorderseite, einer Rückseite und dort angeschlossenen Rückseitenkontakten.

Ein weiterer Gegenstand der vorliegenden Erfindung betrifft ein Verfahren zur Herstellung eines Solarlaminats umfassend wenigstens eine Solarzelle mit einer Vorderseite, einer Rückseite und dort angeschlossenen Rückseitenkontakten, eine Glasscheibe sowie eine Rückseitenfolie, wobei das Verfahren die folgenden Schritte beinhaltet:
a) Auftragen einer wie vorstehend definierten strahlenhärtbaren Harzzusammensetzung auf die Rückseitenfolie und die Glasscheibe des Solarmoduls,
b) Aushärtung der Beschichtungen mittels aktinischer Strahlung
c) Inkontaktbringen der Vorderseite der Solarzelle mit der auf der Glasscheibe erzeugten Harzschicht,
d) Inkontaktbringen der Rückseite der Solarzelle mit der auf der Rückseitenfolie erzeugten Harzschicht,
e) Durchführung der Rückseitenkontakte der Solarzelle durch die Rückseitenfolie,
f) Einbringen des so erzeugten Schichtverbundes in einen Vakuumlaminator zur Entfernung eingeschlossener Luft und
g) Teilaushärtung der verbliebenen Isocyanat- und OH- Funktionalitäten der Harzzusammensetzung in dem Vakuumlaminator unter vermindertem Atmosphärendruck, damit effektive Verklebung von Vorder- und Rückseite des Solarelements und Verkapselung der Solarzelle.

Ein Vorteil der erfindungsgemäßen Verfahren besteht darin, dass zur Laminierung keine hohen Temperaturen erforderlich sind. Eine dauerhafte thermische Belastung des Solarmoduls bis zum Abschluss des Laminierungsprozesses ist folglich nicht erforderlich.

Ein weiterer Gegenstand der vorliegenden Erfindung betrifft ein Verfahren zur Herstellung eines Solarlaminats umfassend wenigstens eine Solarzelle mit einer Vorderseite, einer Rückseite und dort angeschlossenen Rückseitenkontakten, eine Glasscheibe sowie eine Rückseitenfolie, wobei das Verfahren die folgenden Schritte beinhaltet:
a) Auftragen einer wie vorstehend definierten strahlenhärtbaren Harzzusammensetzung auf die Rückseitenfolie des Solarmoduls,
b) Aushärtung der Beschichtungen mittels aktinischer Strahlung,
c) Inkontaktbringen der Rückseite der Solarzelle mit der auf der Rückseitenfolie erzeugten Harzschicht,
d) Durchführung der Rückseitenkontakte der Solarzelle durch die Rückseitenfolie,
e) Auftragen einer strahlenhärtbaren Harzzusammensetzung auf die Vorderseite des nach Schritt d) erhaltenen Solarlaminats,
f) Inkontaktbringen der Vorderseite der Solarzelle mit der Glasscheibe,
g) Einbringen des so erzeugten Schichtverbundes in einen Vakuumlaminator,
h) Teilaushärtung der verbliebenen Isocyanat und OH Funktionalitäten der Harzzusammensetzung in dem Vakuumlaminator unter vermindertem Atmosphärendruck,
i) nach Austrag aus dem Laminator Aushärtung der verbliebenen Doppelbindungen der erfindungsgemäßen Harzzusammensetzung durch aktinische Strahlung durch die mit radikalisch reaktiven Gruppen geprimerte Frontglasscheibe und
j) Verklebung der Glasscheibe mit der Harzmatrix und Verkapselung der Solarzelle.

In vorteilhafter Weise erfolgt bei den erfindungsgemäßen Verfahren die Aushärtung der Polyurethanharzzusammensetzung durch Einwirkung von aktinischer Strahlung, wie UV-Strahlung, Gamma-Strahlung oder Elektronenstrahlung und eine unabhängig ablaufende Polymerisation über eine Reaktion von OH-Gruppen mit den NCO-Gruppen.

Ein weiterer Gegenstand der vorliegenden Erfindung betrifft ein Verfahren zur Herstellung eines Solarlaminats umfassend wenigstens eine Solarzelle mit einer Vorderseite, einer Rückseite und dort angeschlossenen Rückseitenkontakten, eine Glasscheibe sowie eine Rückseitenfolie, wobei das Verfahren die folgenden Schritte beinhaltet:
a) Auftrag eines Klebstoffs auf die Rückseitenfolie und/oder die Rückseite der Solarzelle,
b) Inkontaktbringen und Verkleben der Rückseite der Solarzelle mit der Rückseitenfolie,
c) Durchführung der Rückseitenkontakte der Solarzelle durch die Rückseitenfolie,
d) Auftragen einer wie vorstehend definierten strahlenhärtbaren Harzzusammensetzung auf die Vorderseite des nach Schritt c) erhaltenen Solarlaminats,
e) Aushärtung der Harzzusammensetzung mittels aktinischer Strahlung,
f) optional Schutz der nach e) erhaltenen plan verkapselten Zelle mit einer weiteren Frontseitenfolie oder Glasscheibe in einem Vakuumlaminierprozess und
g) optional Schutz der nach e) erhaltenen plan verkapselten Zelle durch eine oder mehrere weitere Lack-Beschichtungen.

Bevorzugt wird die Rückseite der Solarzelle mit einer geeigneten präparierten bzw. nach gängigen Verfahren oberflächengereinigten, aktivierten, haftvermittelnd ausgerüsteten Rückseitenfolie oder Glasscheibe oder einem anderen stabilisierenden und gegen Umwelteinflüsse ausreichend abschirmendem Untergrund verklebt. Als Klebstoff eignen sich gängige temperatur- und witterungsstabile Klebstoffe wie zum Beispiel reaktive Schmelzklebstoffe, wärmeaktivierbare Klebstoffdispersionen aber auch PVA- und PSA-Klebstoffe auf Acrylat- oder Silikonbasis. Der Klebstoffauftrag kann dabei auf die Solarzelle oder auch auf die Folie bzw. den Untergrund erfolgen. Im Anschluss wird die Vorderseite des so erzeugten Aufbaus der Solarzelle mit der erfindungsgemäß verwendeten Zusammensetzung beschichtet, wobei diese eine plane oder gezielt strukturierte Fläche erzeugt. Die beschichtete Solarzelle wird im Anschluss mit aktinischer Strahlung, Elektronenstrahlung oder Wärme behandelt. Optional kann die so erhaltene Solarzelle mit einer Glasscheibe oder einer transparenten Folie zum Beispiel in einem Vakuumlaminierofen verklebt werden oder mit einer oder mehreren weiteren Lack-Beschichtung versehen werden . Zur vollständigen Aushärtung wird die so erhaltene verkapselte Solarzelle für 10-72h bei Raumtemperatur gelagert. Für eine beschleunigte Aushärtung kann die Lagerung auch bei höheren Temperaturen bis 120°C erfolgen.

In einer besonderen Ausführungsform wird die erfindungsgemäß verwendete Harzformulierung auch zur Verklebung der Solarzellenrückseite verwendet.

Vorteilhaft gegenüber auschließlich radikalisch (UV) vernetzender Beschichtungen wird mit dem erfindungsgemäßen Verfahren ein geringerer Schrumpf sowie eine zuverlässige Aushärtung der Beschichtung auch in Schattenzonen erreicht, was besonders für die Langzeitbeständigkeit der Elemente wichtig ist da im Schattenbereich nicht gehärtete monomere Bestandteile zur Migration, Bläschenbildung und tendenziell Ablösung der Beschichtung neigen.

Die vorliegende Erfindung betrifft ferner ein Solarlaminat, welches nach einem erfindungsgemäßen Verfahren herstellbar ist.

### Beispiele:

Die vorliegende Erfindung wird im Folgenden anhand eines Ausführungsbeispiels näher erläutert:
Im Rahmen des Ausführungsbeispiels wurden die folgenden Chemikalien verwendet:

| | |
|---|---|
| Desmophen® C 1100: | Linearer aliphatischer Polycarbonat-Polyester, Bayer Material Science, Leverkusen (Deutschland), |
| Desmolux® XP 2513: | Ungesättigtes aliphatisches Urethanacrylat, Bayer Material Science, Leverkusen (Deutschland), |
| Desmolux® VP LS 2396: | Isocyanatfunktionelles Urethanacrylat, Bayer Material Science, Leverkusen (Deutschland), |
| IBOA: | Isobornylacrylat, Evonik |
| Irgacure® 2959: | UV-Initiator, BASF |
| AMEO® T | Haftvermittler Evonik |

Zur Herstellung einer erfindungsgemäßen Harzzusammensetzung werden zunächst zwei unmittelbar vor der Anwendung miteinander zu vermischende Komponenten erzeugt. Die erste Komponente umfasst die folgenden Bestandteile:

| **Komponente** | **Masse (g)** | **Gew.%** |
|---|---|---|
| Desmophen® C 1100 | 51,5 | 25,5 |
| Desmolux® XP 2513 | 65,0 | 27,7 |
| IBOA | 32,7 | 16,2 |
| Irgacure® 2959 | 5,9 | 2,9 |

Bei der Herstellung dieser ersten Komponente wird zunächst das Irgacure® 2959 im Isobornylacrylat (IBOA) gelöst und anschließend mit den übrigen Komponenten vermengt.

Die zweite Komponente besteht nur aus dem isocyanatfunktionellen Urethanacrylat:

| **Komponente** | **Masse (g)** | **Gew.%** |
|---|---|---|
| Desmolux® VP LS 2396 | 56,0 | 27,7 |

Zur Herstellung eines Solarlaminats werden die beiden Komponenten sorgsam miteinander vermengt und auf die Rückseitenfolie aufgetragen. Die so erhaltene Beschichtung wird aktinisch gehärtet. Anschließend wird die Solarzelle auf die Rückseitenfolie platziert, mit weiterer Harzformulierung eingegossen, wobei die Rückseitenkontakte der Solarzelle durch entsprechende in der Rückseitenfolie vorgesehene Ausschnitte hindurchgeführt werden. Auf diesen Schichtverbund wird die mit auf der zellenzugewandten Seite mit einem geeigneten Haftvermittler geprimerte Glasscheibe (z.b. mit Aminosilan (AMEO® T Evonik)) gelegt und wird anschließend in eine Vakuumlaminationsapparatur überführt, die vorhandene Luft evakuiert, um hierdurch Lufteinschlüsse zwischen den Klebstoffschichten und den Bauelementen restlos zu entfernen und dann mit Hilfe einer UV-Bogenlampe zur Aushärtung gebracht.

Es wird nach der Aushärtung ein Solarmodul erhalten, welches eine gute mechanische Stabilität aufweist, widerstandsfähig gegen Witterungseinflüsse, und dabei einfach herzustellen ist. Das Solarmodul kann dabei auch in einem kontinuierlichen Verfahren erhalten werden.

## Patentansprüche

1. Verwendung einer strahlenhärtbaren Harzzusammensetzung umfassend wenigstens eine isocyanatfunktionelle Verbindung, die wenigstens eine strahlenhärtende Gruppe ausgewählt aus der Gruppe bestehend aus Vinyl-, Propenyl-, Allyl-, Vinylether-, Maleinyl-, Fumaryl-, Maleinimid-, Dicyclopentadienyl-, Acrylamid- und (Meth)Acrylat-Gruppen aufweist, (Komponente A) und wenigstens ein Polyol (Komponente B) zur Herstellung von Solarlaminaten, umfassend wenigstens eine Solarzelle mit einer Vorderseite, einer Rückseite und dort angeschlossenen Rückseitenkontakten sowie eine Rückseitenfolie, wobei die strahlenhärtbare Zusammensetzung wenigstens einen Initiator (Komponente E) aufweist.

2. Verwendung nach Anspruch 1, **dadurch gekennzeichnet, dass** die strahlenhärtbare Zusammensetzung wenigstens ein ungesättigtes Urethanacrylat, das keine Isocyanatgruppen trägt, (Komponente C) und wenigstens eine (Meth)Acrylatkomponente (Komponente D) aufweist.

3. Verwendung nach Anspruch 1, **dadurch gekennzeichnet, dass** die isocyanatfunktionelle Verbindung (Meth)Acrylat-Gruppen aufweist.

4. Verwendung nach Anspruch 1, **dadurch gekennzeichnet, dass** die isocyanatfunktionelle Verbindung, die wenigstens eine strahlenhärtende Gruppe ausgewählt aus der Gruppe bestehend aus Vinyl-, Propenyl-, Allyl-, Vinylether-, Maleinyl-, Fumaryl-, Maleinimid-, Dicyclopentadienyl-, Acrylamid- und (Meth)Acrylat-Gruppen aufweist, ein isocyanatfunktionelles Urethanacrylat ist.

5. Verwendung nach Anspruch 4, **dadurch gekennzeichnet, dass** isocyanatfunktionelle Urethanacrylat eine NCO-Funktionalität von 0,8 bis 6 aufweist.

6. Verwendung nach einem der vorstehend genannten Ansprüche, **dadurch gekennzeichnet, dass** die strahlenhärtbare Harzzusammensetzung frei von organischen Lösungsmitteln mit einem Siedepunkt < 150 °C ist.

7. Verwendung nach Anspruch 1, **dadurch gekennzeichnet, dass** das Polyol eine OH-Funktionalität von 1 bis 6 aufweist.

8. Verwendung nach Anspruch 1, **dadurch gekennzeichnet, dass** das ungesättigtes Urethanacrylat, das keine Isocyanatgruppen trägt, (Komponente C), eine Doppelbindungsfunktionalität von 1 bis 6 aufweist.

9. Verwendung nach Anspruch 1, **dadurch gekennzeichnet, dass** das ungesättigtes Urethanacrylat, das keine Isocyanatgruppen trägt, (Komponente C), ein ungesättigtes aliphatisches Urethanacrylat ist.

10. Verwendung nach Anspruch 1, **dadurch gekennzeichnet, dass** die (Meth)Acrylatkomponente (Komponente D) ausgewählt wird aus der Gruppe bestehend aus Isobornyl(meth)acrylat, Tetrahydrofufurylacrylat, 2-Ethyloctylacrylat, 2-Ethylhexylacrylat und Ethoxyethoxyethylacrylat.

11. Verfahren zur Herstellung eines Solarlaminats umfassend wenigstens eine Solarzelle mit einer Vorderseite, einer Rückseite und dort angeschlossenen Rückseitenkontakten, eine Glasscheibe sowie eine Rückseitenfolie, wobei das Verfahren die folgenden Schritte umfasst
a) Auftragen einer strahlenhärtbaren Harzzusammensetzung nach einem oder mehreren der Ansprüche 1 bis 10 auf die Rückseitenfolie und die Glasscheibe des Solarmoduls,
b) Aushärtung der Beschichtungen mittels aktinischer Strahlung
c) Inkontaktbringen der Vorderseite der Solarzelle mit der auf der Glasscheibe erzeugten Harzschicht,
d) Inkontaktbringen der Rückseite der Solarzelle mit der auf der Rückseitenfolie erzeugten Harzschicht,
e) Durchführung der Rückseitenkontakte der Solarzelle durch die Rückseitenfolie,
f) Einbringen des so erzeugten Schichtverbundes in einen Vakuumlaminator zur Entfernung eingeschlossener Luft und
g) Teilaushärtung der verbliebenen Isocyanat und OH Funktionalitäten der Harzzusammensetzung in dem Vakuumlaminator unter vermindertem Atmosphärendruck, damit effektive Verklebung von Vorder- und Rückseite des Solarelements und Verkapselung der Solarzelle.

12. Verfahren zur Herstellung eines Solarlaminats umfassend wenigstens eine Solarzelle mit einer Vorderseite, einer Rückseite und dort angeschlossenen Rückseitenkontakten, sowie eine Rückseitenfolie, wobei das Verfahren die folgenden Schritte umfasst
a) Auftragen einer strahlenhärtbaren Harzzusammensetzung nach einem oder mehreren der Ansprüche 1 bis 10 auf die Rückseitenfolie des Solarmoduls,
b) Aushärtung der Beschichtungen mittels aktinischer Strahlung
c) Inkontaktbringen der Rückseite der Solarzelle mit der auf der Rückseitenfolie erzeugten Harzschicht,
d) Durchführung der Rückseitenkontakte der Solarzelle durch die Rückseitenfolie,
e) Auftragen einer strahlenhärtbaren Harzzusammensetzung auf die Vorderseite des nach Schritt d) erhaltenen Solarlaminats,
f) Inkontaktbringen der Vorderseite der Solarzelle mit der Glasscheibe,
g) Einbringen des so erzeugten Schichtverbundes in einen Vakuumlaminator, und
h) Teilaushärtung der verbliebenen Isocyanat- und OH- Funktionalitäten der Harzzusammensetzung m dem Vakuumlaminator unter vermindertem Atmosphärendruck und
i) nach Austrag aus dem Laminator Aushärtung der verbliebenen Doppelbindungen der erfindungsgemäßen Harzzusammensetzung durch aktinische Strahlung durch die mit radikalisch reaktiven Gruppen geprimerte Frontglasscheibe und
j) Verklebung der Glasscheibe mit der Harzmatrix und Verkapselung der Solarzelle.

13. Verfahren zur Herstellung eines Solarlaminats umfassend wenigstens eine Solarzelle mit einer Vorderseite, einer Rückseite und dort angeschlossenen Rückseitenkontakten, sowie eine Rückseitenfolie, wobei das Verfahren die folgenden Schritte umfasst
a) Auftrag eines Klebstoffs auf die Rückseitenfolie und/oder die Rückseite der Solarzelle,
b) Inkontaktbringen und Verkleben der Rückseite der Solarzelle mit der Rückseitenfolie,
c) Durchführung der Rückseitenkontakte der Solarzelle durch die Rückseitenfolie,
d) Auftragen einer strahlenhärtbaren Harzzusammensetzung nach einem oder mehreren der Ansprüche 1 bis 10 auf die Vorderseite des nach Schritt c) erhaltenen Solarlaminats,
e) Aushärtung der Harzzusammensetzung mittels aktinischer Strahlung,
f) optional Schutz der nach e) erhaltenen plan verkapselten Zelle mit einer weiteren Frontseitenfolie oder Glasscheibe in einem Vakuumlaminierprozess und
g) optional Schutz der nach e) erhaltenen plan verkapselten Zelle durch eine oder mehrere weitere Lack-Beschichtungen.

14. Solarlaminat hergestellt nach einem Verfahren gemäß Anspruch 11 oder 12 oder 13.

## Claims

1. Use of a radiation-curable resin composition comprising at least one isocyanate-functional compound (component A) which includes at least one radiation-curable group selected from the group consisting of vinyl, propenyl, allyl, vinyl ether, maleinyl, fumaryl, maleimide, dicyclopentadienyl, acrylamide and (meth)acrylate groups, and at least one polyol (component B) for the preparation of solar laminates comprising at least one solar cell having a front side, a rear side and rear side contacts connected thereto and a rear side foil, wherein the radiation-curable composition comprises at least one initiator (component E).

2. Use according to claim 1, **characterized in that** the radiation-curable composition comprises at least one unsaturated urethane acrylate (component C) which carries no isocyanate groups, and at least one (meth)acrylate component (component D).

3. Use according to claim 1, **characterized in that** the isocyanate-functional compound comprises (meth)acrylate groups.

4. Use according to claim 1, **characterized in that** the isocyanate-functional compound which comprises at least one radiation-curable group selected from the group consisting of vinyl, propenyl, allyl, vinyl ether, maleinyl, fumaryl, maleimide, dicyclopentadienyl, acrylamide and (meth)acrylate groups, is an isocyanate-functional urethane acrylate.

5. Use according to claim 4, **characterized in that** the isocyanate-functional urethane acrylate has an NCO functionality of 0.8 to 6.

6. Use according to any one of the preceding claims, **characterized in that** the radiation-curable resin composition is free of organic solvents having a boiling point of < 150°C.

7. Use according to claim 1, **characterized in that** the polyol has an OH functionality of 1 to 6.

8. Use according to claim 1, **characterized in that** the unsaturated urethane acrylate (component C) which carries no isocyanate groups, has a double bond functionality of 1 to 6.

9. Use according to claim 1, **characterized in that** the unsaturated urethane acrylate (component C), which carries no isocyanate groups, is an unsaturated aliphatic urethane acrylate.

10. Use according to claim 1, **characterized in that** the (meth)acrylate component (component D) is selected from the group consisting of isobornyl(meth)acrylate, tetrahydrofurfuryl acrylate, 2-ethyloctyl acrylate, 2-ethylhexyl acrylate and ethoxyethoxy ethyl acrylate.

11. Method for producing a solar laminate comprising at least one solar cell having a front side, a rear side and rear side contacts connected thereto, a glass sheet and a rear side foil, wherein the method comprises the following steps:
a) applying a radiation-curable resin composition according to one or more of claims 1 to 10 onto the rear side foil and the glass sheet of the solar module;
b) curing the coatings by means of actinic radiation;
c) contacting the front side of the solar cell with the resin layer formed on the glass sheet;
d) contacting the rear side of the solar cell with the resin layer formed on the rear side foil;
e) passing the rear side contacts of the solar cell through the rear side foil;
f) introducing the layer composite thus produced into a vacuum laminator for removing trapped air; and
g) partially curing the remaining isocyanate and OH functionalities of the resin composition in the vacuum laminator under reduced atmospheric pressure in order to achieve an effective bonding of the front and rear side of the solar element and an encapsulation of the solar cell.

12. Method for producing a solar laminate comprising at least one solar cell having a front side, a rear side and rear side contacts connected thereto, and a rear side foil, wherein the method comprises the following steps:
a) applying a radiation-curable resin composition according to one or more of claims 1 to 10 onto the rear side foil of the solar module;
b) curing the coatings by means of actinic radiation;
c) contacting the rear side of the solar cell with the resin layer produced on the rear side foil;
d) passing the rear side contacts of the solar cell through the rear side foil;
e) applying a radiation-curable resin composition onto the front side of the solar laminate obtained according to step d);
f) contacting the front side of the solar cell with the glass sheet;
g) introducing the layer composite thus produced into a vacuum laminator;
h) partially curing the remaining isocyanate and OH functionalities of the resin composition in the vacuum laminator under reduced atmospheric pressure;
i) after discharge from the laminator, curing the remaining double bonds of the resin composition according to the invention by actinic radiation through the front glass sheet primed with radically reactive groups; and
j) gluing together the glass sheet and the resin matrix and encapsulating the solar cell.

13. Method for producing a solar laminate comprising at least one solar cell having a front side, a rear side and rear side contacts connected thereto, and a rear side foil, wherein the method comprises the following steps:
a) applying an adhesive onto the rear side foil and/or the rear side of the solar cell;
b) contacting and bonding the rear side of the solar cell with the rear side foil;
c) passing the rear side contacts of the solar cell through the rear side foil;
d) applying a radiation-curable resin composition according to one or more of claims 1 to 10 onto the front side of the solar laminate obtained according to step c);
e) curing the resin composition by means of actinic radiation;
f) optionally protecting the plane encapsulated cell obtained according to step e) with another front side foil or glass sheet in a vacuum lamination process; and
g) optionally protecting the plane encapsulated cell obtained according to step e) by one or more further lacquer coatings.

14. Solar laminate produced by a method according to claim 11, 12 or 13.

## Revendications

1. Utilisation d'une composition de résine durcissable par rayonnement comprenant au moins un composé à fonction isocyanate qui présente au moins un groupe durcissable par rayonnement sélectionné dans le groupe constitué des groupements vinyle, propényle, allyle, vinyléther, maléinyle, fumaryle, maléinimide, dicyclo pentadiényle, acrylamide et (méth)acrylate, (la composante A), et au moins un polyol (la composante B) pour la fabrication de stratifiés solaires, comprenant au moins une cellule solaire avec une face avant, une face arrière et des contacts de face arrière y étant rapportés, ainsi qu'un film de face arrière, où la composition durcissable par rayonnement présente au moins un initiateur (la composante E).

2. Utilisation selon la revendication 1, **caractérisée en ce que** la composition durcissable par rayonnement présente au moins un uréthane acrylate insaturé qui ne porte pas de groupe isocyanate, (la composante C), et au moins une composante (méth)acrylate (la composante D).

3. Utilisation selon la revendication 1, **caractérisée en ce que** le composé à fonction isocyanate présente des groupes (méth)acrylate.

4. Utilisation selon la revendication 1, **caractérisée en ce que** le composé à fonction isocyanate qui présente au moins un groupe durcissable par rayonnement sélectionné dans le groupe constitué des groupements vinyle, propényle, allyle, vinyléther, maléinyle, fumaryle, maléinimide, dicyclo pentadiényle, acrylamide et (méth)acrylate, est un uréthane acrylate à fonction isocyanate.

5. Utilisation selon la revendication 4, **caractérisée en ce que** l'uréthane acrylate à fonction isocyanate présente une fonctionnalité NCO de 0,8 à 6.

6. Utilisation selon l'une des revendications citées précédemment, **caractérisée en ce que** la composition de résine durcissable par rayonnement est exempte de solvants organiques avec un point d'ébullition < 150 °C.

7. Utilisation selon la revendication 1, **caractérisée en ce que** le polyol présente une fonctionnalité OH de 1 à 6.

8. Utilisation selon la revendication 1, **caractérisée en ce que** l'uréthane acrylate insaturé qui ne porte pas de groupe isocyanate, (la composante C), présente une fonctionnalité de double liaison de 1 à 6.

9. Utilisation selon la revendication 1, **caractérisée en ce que** l'uréthane acrylate insaturé qui ne porte pas de groupe isocyanate, (la composante C), est un uréthane acrylate aliphatique insaturé.

10. Utilisation selon la revendication 1, **caractérisée en ce que** la composante (méth)acrylate (la composante D) est choisie dans le groupe constitué d'isobomyl (méth)acrylate, de tétrahydro furfuryl acrylate, de 2-éthyloctyl acrylate, de 2-éthylhexyl acrylate et d'éthoxy éthoxyéthyl acrylate.

11. Procédé de fabrication d'un stratifié solaire comprenant au moins une cellule solaire avec une face avant, une face arrière et des contacts de face arrière y étant rapportés, un vitre en verre ainsi qu'un film de face arrière, où le procédé comprend les étapes suivantes
a) de dépôt d'une composition de résine durcissable par rayonnement selon une ou plusieurs parmi les revendications 1 à 10 sur le film de face arrière et sur la vitre en verre du module solaire,
b) de durcissement des revêtements au moyen d'un rayonnement actinique
c) de mise en contact de la face avant de la cellule solaire avec la couche de résine créée sur la vitre en verre,
d) de mise en contact de la face arrière de la cellule solaire avec la couche de résine créée sur le film de face arrière,
e) d'exécution des contacts avec les faces arrières de la cellule solaire par le film de face arrière,
f) d'introduction du composite stratifié ainsi créé dans un système de laminage sous vide pour le retrait de l'air emprisonné, et
g) de durcissement partiel des fonctionnalités isocyanate restant et OH de la composition de résine dans le système de laminage sous vide sous une pression d'atmosphère réduite afin d'avoir un collage efficace des faces avant et arrière de l'élément solaire et un encapsulage de la cellule solaire.

12. Procédé de fabrication d'un stratifié solaire comprenant au moins une cellule solaire avec une face avant, une face arrière et des contacts de face arrière y étant rapportés, ainsi qu'un film de face arrière, où le procédé comprend les étapes suivantes
a) de dépôt d'une composition de résine durcissable par rayonnement selon une ou plusieurs parmi les revendications 1 à 10 sur le film de face arrière du module solaire,
b) de durcissement des revêtements au moyen d'un rayonnement actinique
c) de mise en contact de la face arrière de la cellule solaire avec la couche de résine créée sur le film de face arrière,
d) d'exécution des contacts avec les faces arrières de la cellule solaire par le film de face arrière,
e) de dépôt d'une composition de résine durcissable par rayonnement sur la face avant du stratifié solaire obtenu selon l'étape d),
f) de mise en contact de la face avant de la cellule solaire avec la vitre en verre,
g) d'introduction du composite stratifié ainsi créé dans un système de laminage sous vide, et
h) de durcissement partiel des fonctionnalités isocyanate restant et OH de la composition de résine dans le système de laminage sous vide sous une pression d'atmosphère réduite, et
i) après le retrait du système de laminage, de durcissement des doubles liaisons résiduelles de la composition de résine selon l'invention par un rayonnement actinique par la vitre en verre avant enduite de primaire par les groupes radicalaires réactifs et
j) de collage de la vitre en verre avec la matrice de résine et d'encapsulage de la cellule solaire.

13. Procédé de fabrication d'un stratifié solaire comprenant au moins une cellule solaire avec une face avant, une face arrière et des contacts de face arrière y étant rapportés, ainsi qu'un film de face arrière, où le procédé comprend les étapes suivantes
a) de dépôt d'un adhésif sur le film de face arrière et/ou la face arrière de la cellule solaire,
b) de mise en contact et de collage de la face arrière de la cellule solaire avec le film de face arrière,
c) d'exécution des contacts avec les faces arrières de la cellule solaire par le film de face arrière,
d) de dépôt d'une composition de résine durcissable par rayonnement selon une ou plusieurs parmi les revendications 1 à 10 sur la face avant du stratifié solaire obtenu selon l'étape c),
e) de durcissement de la composition de résine au moyen d'un rayonnement actinique,
f) de protection éventuelle de la cellule encapsulée plane obtenue après e) avec un nouveau film de face avant ou une vitre en verre dans un processus de laminage sous vide, et
g) de protection éventuelle de la cellule encapsulée plane obtenue après e) par un ou plusieurs revêtements de laque ultérieurs.

14. Stratifié solaire fabriqué selon un procédé selon la revendication 11 ou la revendication 12 ou la revendication 13.
